# EUROPEAN PATENT APPLICATION

(11) **EP 1 785 738 A2**
(43) Date of publication of application: **16.05.2007**
(21) Application number: 06122001.8
(22) Date of filing: 09.10.2006
(51) Int. Cl.: G01R 33/04

(54) **Magnetic sensor, particularly for measuring the position and movement of an object, and related manufacturing method**

(30) Priority: 09.11.2005 IT MO20050293
(71) Applicant: M.D. MICRO DETECTORS S.p.A., I-41100 Modena (IT)
(72) Inventor: DEL MONTE, Mauro, 41100, MODENA (IT)
(74) Representative: Modiano, Micaela Nadia

(57) **Abstract**

A magnetic sensor (1), particularly for measuring the position and movement of an object, comprising at least one winding of electrically conducting material that is arranged around a magnetic core (2), the magnetic core (2) comprising at least one layer of magnetic material (3) and being interposed between at least two plates (4) of dielectric material that are provided with respective conductive tracks (5) that are mutually connected to form such at least one winding.

## Description

The present invention relates to a magnetic sensor, particularly for measuring the position and movement of an object, and the related method of manufacturing the sensor.

Magnetic sensors are known in the field of electronic surveyors, in particular, for measuring the position and/or the linear or angular movement of an object, for the surveying of the nearness of metallic objects, and, a not last application, for the measurement of intensity of magnetic fields.

There are known magnetic sensors that comprise a group of metallic reels that are constituted by electrically conductive wires, mutually insulated and tidily overlapped, and that are wound about an appropriately shaped core of magnetic material.

These known magnetic sensors are not free from drawbacks, among which is the fact that their structure and the particular component elements utilized do not allow a series production of a large number of units at a contained cost.

To this there is added the fact that the known sensors do not respect the required minimums of miniaturization. This implies that it is not possible to manufacture known magnetic sensors with reduced dimensions without prejudicing their functionality and efficiency.

The manufacturing methods of such known sensors require, moreover, large fields of tolerance, related mainly to the presence of a margin of error during the positioning of the metallic turns, united to the necessity to respect the required minimum spacing between two successive turns.

A not last drawback relates to the possibility of breakages, such as short-circuits, due to accidental contacts between the turns, or the possible breaking of the turn itself with the interruption of the electronic circuit segment constituted by the winding about the magnetic core.

The aim of the present invention is to eliminate the above-described drawbacks of the prior art, by providing a magnetic sensor, particularly for measuring the position and movement of an object, that is manufacturable in series with contained costs.

Another object of the invention is to provide a magnetic sensor that is manufacturable with reduced dimensions without compromising its functionality and efficiency.

A further object of the invention is to provide a magnetic sensor obtainable by means of methods that guarantee negligible margins of error during the different phases of manufacture.

Another object of the invention is to provide a magnetic sensor that limits the possibilities of breakages such as short-circuits or interruptions of the electrical circuit due to the breakage of one or more of the turns of the winding.

Within this aim, another object of the present invention is to provide a simple structure, of relatively easy practical actuation, of secure use and effective functioning, as well as of relatively contained costs.

This aim and these and other objects that will become better apparent hereinafter are achieved by the present magnetic sensor, particularly for measuring the position and movement of an object, comprising at least one winding of electrically conducting material that is arranged around a magnetic core, characterized in that the magnetic core comprises at least one layer of magnetic material and is interposed between at least two plates of dielectric material that are provided with respective conductive tracks that are mutually connected to form such at least one winding.

This aim and these objects are also achieved by a method for manufacturing a magnetic sensor, chracterized in that it comprises the steps of: providing a magnetic core; interposing the magnetic core between at least two plates of dielectric material; forming conductive tracks on respective opposing faces of such at least two tracks and connecting said tracks on opposed faces to define at least one electrically conductive winding around said magnetic core.

Further characteristics and advantages of the present invention will become better apparent from the following detailed description of a preferred, but not exclusive, embodiment of a magnetic sensor, illustrated by way of non-limiting example in the accompanying drawings, in which:

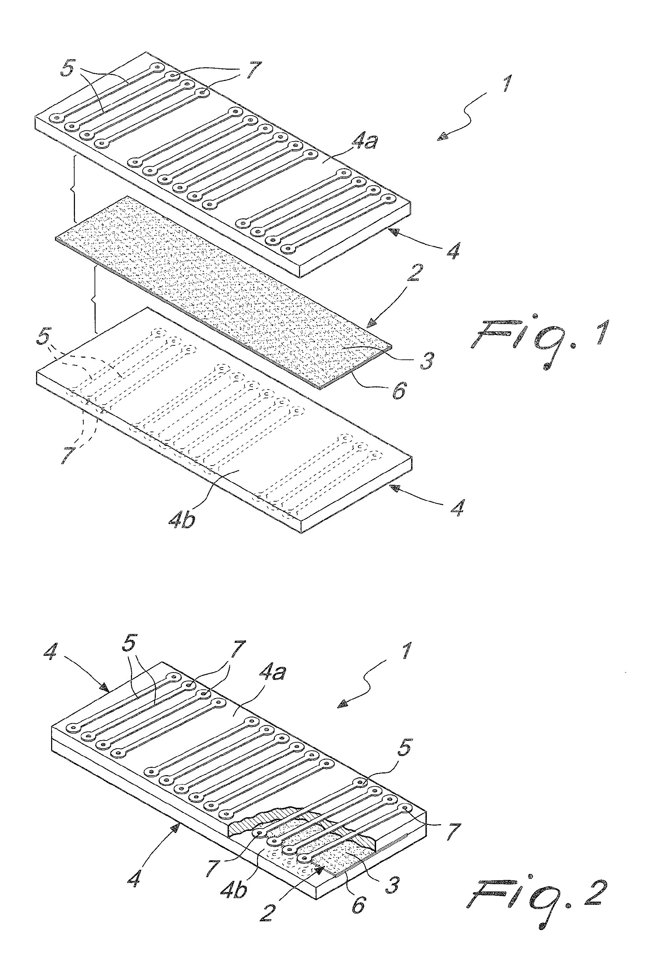

Figure 1 is an exploded schematic view of the magnetic sensor according to the invention;
Figure 2 is a partially sectional perspective schematic view of the magnetic sensor according to the invention;

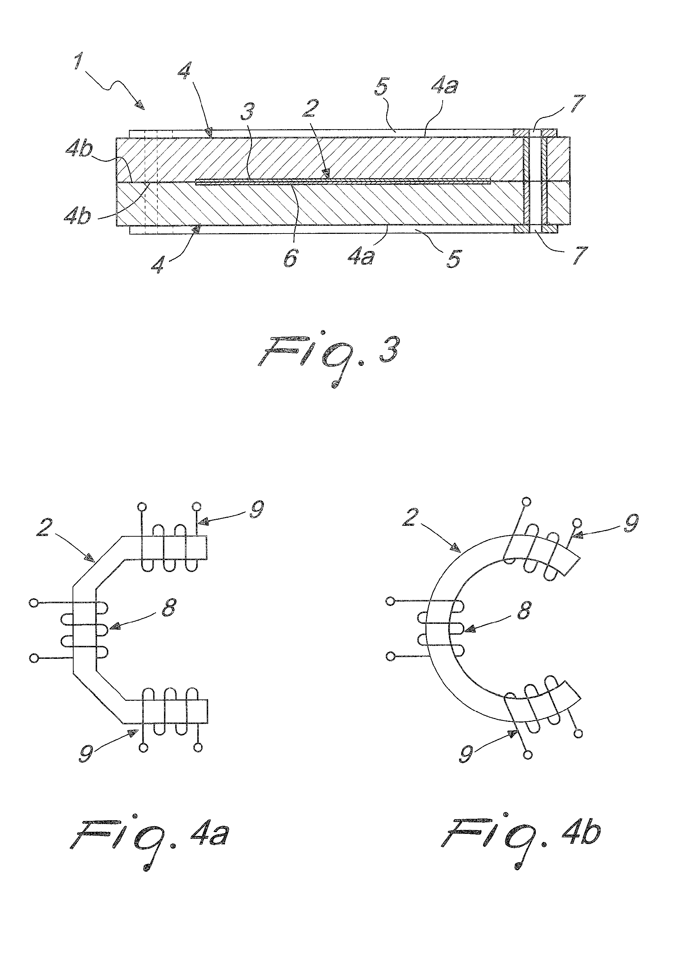

Figure 3 is sectional schematic front view of the magnetic sensor according to the invention;
Figures 4a to 4f schematically illustrate different possible implementations of the magnetic sensor according to the invention;
Figure 5 is an exploded schematic view of a second embodiment of the sensor according to the invention;
Figure 6 is a circuit diagram respresenting the use and functioning of the magnetic sensor according to the invention for the measuring of the position and/or movement of an object;
Figure 7 is a perspective schematic view in which there is shown the magnetic sensor according to the invention used for measuring the position or the angular movement of an object;
Figures 8a to 8e are front schematic views that illustrate the method manufacturing steps of the magnetic sensor according to the invention.

With reference to the figures, there is indicated globally with the reference numeral 1 a magnetic sensor, particularly for measuring the position and the movement of an object.

The magnetic sensor 1 comprises a core 2 of magnetic material that has at least one layer of magnetic material 3 and is interposed between at least two plates 4 of dielectric material.

Conductive tracks 5 are defined on respective opposite faces of the two plates 4, preferably on the external faces 4a, and are mutually connected to form at least one winding or reel arranged around the magnetic core 2.

In particular, the core 2 is substantially plate-shaped and comprises at least one support layer 6 for the magnetic material layer 3 adapted to increase the mechanical strength of the core 2 and constituting, at the same time, a substrate suitable for its successive shaping and integration inside the structure of the sensor 1, between the plates 4.

The structure of the core 2 may be provided in a different manner and it may comprise, for example, a plurality of magnetic material layers 3 and a plurality of support layers 6 alternatively superimposed between themselves.

The magnetic material layer 3 is preferably constituted by soft magnetic alloys with high permeability and commercially available in rolls or ribbons of thin laminates, sheets or strips. There are generally available alloys in the crystalline, nano-crystalline, or amorphous state of different compositions and properties.

Recently, the shapes in which such alloys are produced and commercialised, in particular the sheets and the rolls of adequate width, are well suited to the integration in the greater part of fabrication techniques of printed circuits.

Moreover, the availability of magnetic materials in the shape of films, pastes or inks, allows to provide the magnetic core 2 by selective deposition or printing.

Advantageously, the magnetic material layer 3 is provided either as a rigid-type material, or as a flexible-type material.

The magnetic material layer 3 and, eventually, the support layer 6 are interposed and fixed by gluing between the two plates 4 and in correspondence of respective internal faces 4b opposite to the respective external faces 4a.

The conductive tracks 5 that are defined on the opposing external faces 4a are mutually connected by at least one conductive through hole 7; in particular, on each of the external faces 4a, there is present a plurality of such conductive tracks 5 shaped substantially in linear segments that are mutually spaced and parallel.

Each of the segments that is defined on one of the plates 4 is preferably inclined with respect to at least one respective segment on the other plate 4, and it is connected thereto, at respective longitudinal ends and by means of a conductive hole 7, to form a zig-zag path about the core 3 and, therefore, to form a winding.

Advantageously, as shown in the particular but not limiting embodiment illustrated in the figures, the plates 4 have a substantially elongated shape and the core 3 is interposed axially therebetween and for all of their length. The conductive tracks 5 are mutually connected to define a primary winding 8, with a substantially central arrangement with respect to the sensor 1, and two secondary windings 9 arranged in proximity to the longitudinal ends of the plates 4.

The secondary windings 9 may be, in case, employed separately or mutually connected, with the same or reverse direction of winding, in order to implement an opportune measurement strategy.

With the exception of the magnetic core 2, the materials employed for the manufacture of the magnetic sensor 1 according to the invention may be chosen among those conventionally employed in known manufacturing methods of printed circuits.

The plates 4 and the support layer 6 may be provided, for example, in epoxide resins, mixtures of epoxide resins, BT resin, ester cynates, polyimide, polyester, PTFE, and APPE.

Advantageously, the plates 4 and the support layer 6 may alternatively be provided in flexible-type material, for example, polyamide, polyester, FEP or paper impregnated with resin.

Moreover, in the implementation with flexible materials, it is possible to use adhesives for gluing the magnetic core 2 to the plates 4, such as acrylic, epoxy or phenolic resins, or pressure sensitive adhesives.

The conductive tracks 5 and the conductive holes 7 may be provided in copper or in any other type of conductive material conventionally used in printed circuit technology, for example aluminium or silver, or in the alternative, they may be provided using conductive pastes or inks.

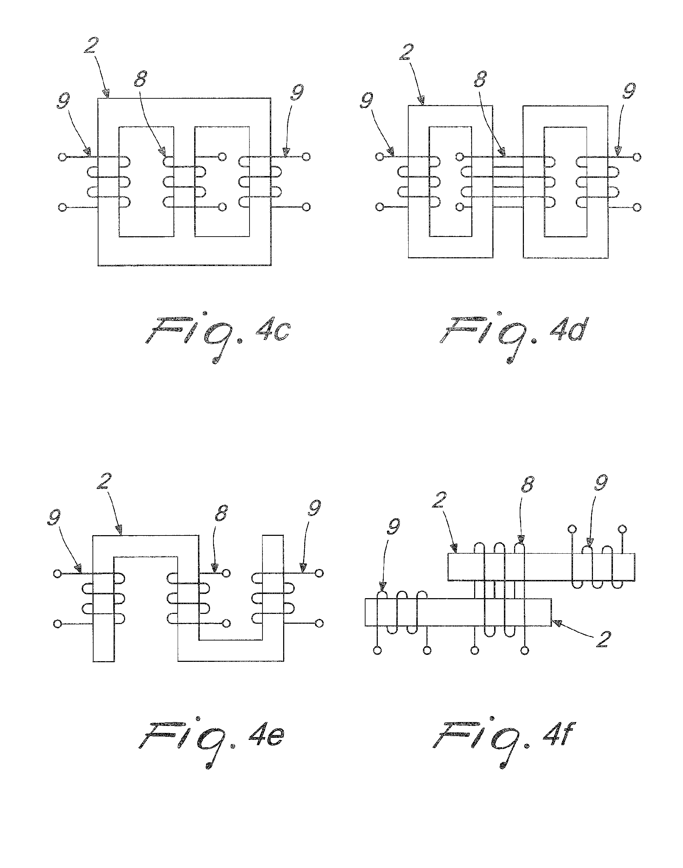

As it is illustrated schematically in Figures 4a to 4f, depending on the type of use of the magnetic sensor 1, there are provided different embodiments with a different number and arrangement of the primary and secondary windings 8, 9, with different arrangement of the magnetic core 2 and with its shape adapted, for example, to define a magnetic circuit that is closed, open, and with one or more branches.

In particular, Figures 4a and 4b schematically illustrate two possible implementations of a magnetic sensor 1 adapted to measure the position or angular movement of an object.

Figures 4c to 4f schematically illustrate further possible embodiments of a magnetic sensor 1 for detecting the proximity of metallic objects and/or for measuring magnetic field intensity.

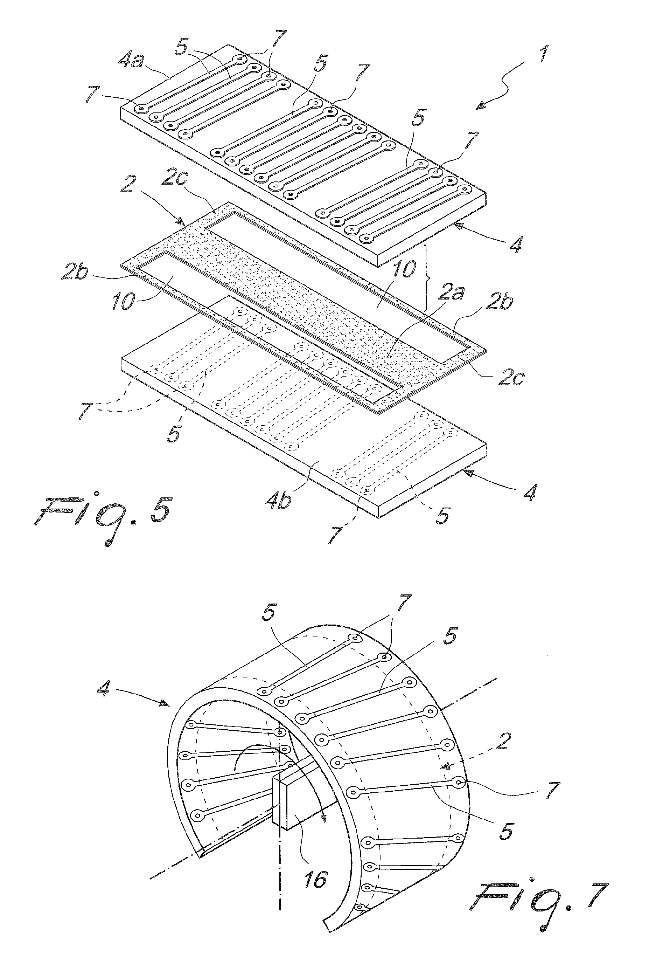

With reference to the embodiment illustrated in Figure 5, the magnetic core 1 comprises a central branch 2a arranged axially to the plates 4 and for their entire length, about which the primary winding 8 and the two secondary windings 9 are wound.

Two secondary branches 2b are arranged parallel and at a distance to the central branch 2a and are coupled thereto at the respective ends by transverse portions 2c to provide two slots 10 adapted to be traversed by the conductive holes 7.

The closed magnetic circuit thus constructed by the central branch 2a and by the two secondary branches 2b is designed to be traversed by the flux line of the magnetic field generated by the passage of current through the primary winding 8 and/or the secondary windings 9.

A closed magnetic core 2 allows to obtain increased inductance and sensibility values for the magnetic core 1.

A first application of the magnetic sensor 1 according to the invention is the measuring of the position and of the movement of an object.

In this case, the functioning of the magnetic sensor 1 is illustrated in the circuit diagram of Figure 6, in which the magnetic sensor 1 has a similar structure to that described above, with a magnetic core 2 with one or more branches.

The primary winding 8 is connected to a signal source, such as for example a sinusoidal current generator with constant amplitude, indicated with the reference numeral 14 in Figure 6. The current iₚ produced by the generator 14 passes through the primary winding 8 and generates a magnetic flux that passes through the magnetic core 2. Such magnetic flux induces electromotive forces to the heads of the secondary windings 9, mutually connected by a conditioning circuit that comprises a measuring device 15 of an exit signal.

An object provided with a magnetic target 16, constituted for example by a permanent magnet or by a generic body comprising at least one of its parts being opportunely magnetized, if arranged in proximity to the magnetic sensor 1, induces a local saturation on at least one portion of the magnetic core 2, creating a saturated area 17 that functions as an air gap that interrupts, in such portion, the magnetic circuit defined by the same core.

By changing the position of the magnetic object 16 with respect to the magnetic sensor 1 the arrangement of the saturated area 17 on the magnetic core 2 consequently changes.

When the magnetic target 16 is positioned at the central portion of the magnetic core 2, corresponding to the start of the reference system illustrated in Figure 6, the saturated area 17 interrupts the magnetic circuit defined by the magnetic core 2 dividing it into two mutually symmetrical portions. As a consequence, the electromagnetic forces induced on the secondary windings 9 are substantially identical and the exit signal detected by the measuring device 15 is substantially zero.

When, instead, the magnetic target 16 occupies a different position than that of the central position described above, the magnetic core 2 is divided by the saturated area 17 into two mutually non-symmetric portions, to generate induced electromotive forces that are different on respective secondary windings 9, and as a consequence, a non-zero exit signal measurable by means of the measuring device 15.

A suitable design of the magnetic sensor 1, of the magnetic target 16, and of the conditioning circuit, allows to define a linear relationship between the position of the object 16 relative to the magnetic sensor 1 and the detected exit signal.

A second application of the magnetic sensor 1 is to measure the position and the angular movement of an object.

In this case the employed functioning principle is the same as described above, and as it is illustrated in Figure 7, the magnetic sensor 1 is completely provided in flexible-type material and it wraps about a rotating object at a magnetic target 16 fit on the rotation axis of the object.

A third application of the magnetic sensor 1 is to detect the proximity of a metallic object.

The magnetic sensor 1 comprises in this case at least one primary winding 8 and an open magnetic core 2. The winding 8 is crossed by a signal generated, for example, by a sinusoidal current generator, that induces a magnetic field that passes through the magnetic core 2 and through part of the space surrounding the core itself. A metallic object, arranged in proximity to the sensor 1 and hit by such magnetic field, is passed over by induced parasitic currents that generate, in turn, a second magnetic field that couples with that generated by the magnetic sensor 1, to change the inductance measurable at the heads of the primary winding 8. Such change in inductance is detectable and correlatable to the position of the metallic object with respect to the magnetic sensor 1.

It is not excluded the possibility to use distinct secondary windings 9, for actuating the generated magnetic field and for measuring the induced magnetic field, respectively.

A forth application of the magnetic sensor 1 is to measure the intensity of an external magnetic field.

In this case the magnetic core 2 is forced, with an opportune excitation of the primary winding 8, to pass through its hysteresis loop, which is alteratable by an external magnetic field to be measured. In particular, the external magnetic field influences the changes of measurable inductance to the heads of the primary winding 8, which changes are detectable and correlatable to the intensity of the external magnetic field.

The magnetic sensor 1 may be provided by means of a method defined by any, appropriate, combination of techniques, processes or methodologies generally employed in the manufacture of printed circuits.

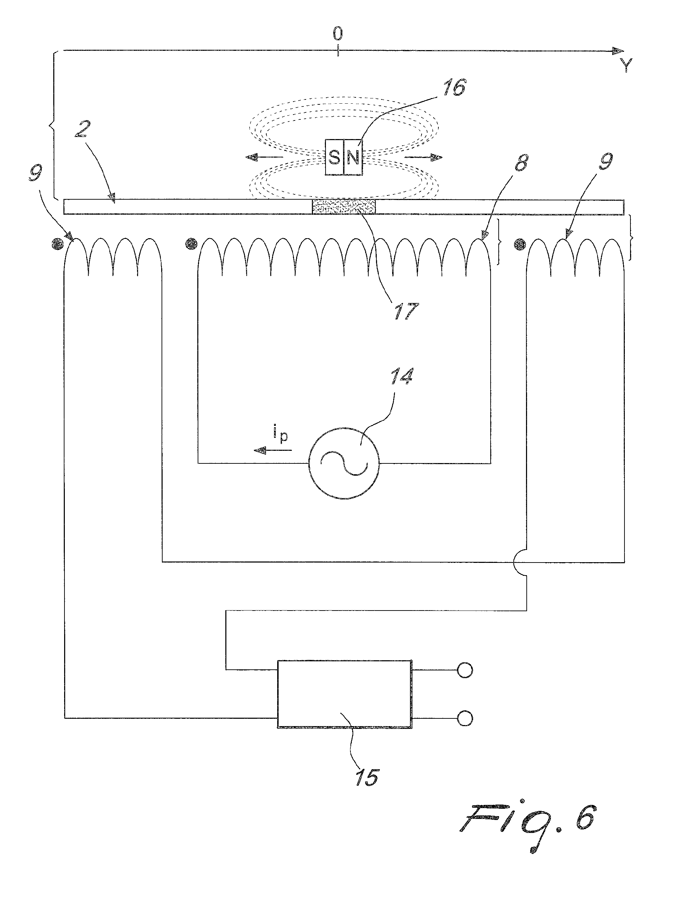

With particular but not exclusive reference to the sensor 1 described above, and with particular reference to Figures 8a to 8e, the manufacturing process of the magnetic core 2 comprises the arrangement of the magnetic core 2 between the dielectric plates 4 by lamination in a single integrated structure, the provision of conductive tracks 5 on the respective opposed external faces 4a of the plates 4 and of the conductive interconnection holes 7 between such conductive tracks 5 of one of the plates 4 with the conductive tracks 5 of the other one of the plates 4 to form at least one electrically conductive winding arranged about the magnetic core 2.

In particular, the production of the magnetic core 2 comprises fixing, by means of overlapping and gluing, the layer of magnetic material 3, in the shape of a tape of sheet of soft magnetic alloy, on the support layer 6, constituted for example by at least one sheet of prepreg.

Alternatively, magnetic-type material is selectively deposited or printed on the support layer 6.

The layers glued in this manner, as shown in Figures 8a and 8b, are shaped by means of mechanical process, such as for example, cutting, milling, or drilling, for opportunely forming the magnetic core 2, depending upon the particular type of use of the magnetic sensor 1; during this shaping phase the support layer 6 gives the magnetic material layer 3 an increased mechanical resistance.

The subsequent lamination phase comprises the gluing of the magnetic core 2 at the internal faces 4b of the plates 4 by interposing adhesive layers.

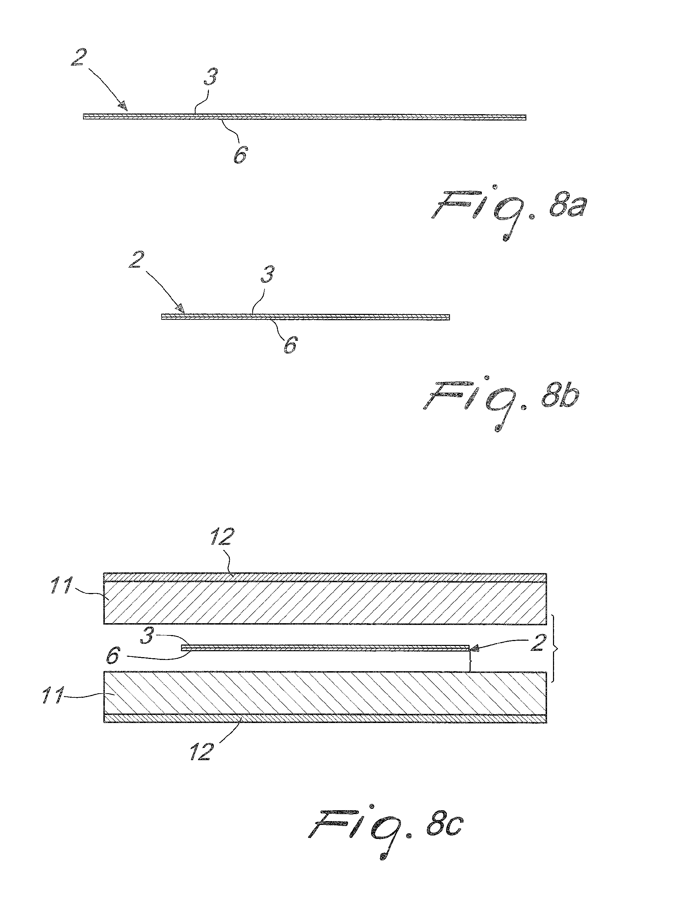

In particular, as seen in Figure 8c, the plates 4 are constituted, for example, by two laminated elements 11 provided, at the respective external faces 4a, with conductive surfaces 12 constituted by a copper coating. The shaped magnetic core 2 is inserted between the plates 4 at the respective internal faces 4b and, after a cycle of hot or cold pressing, the two laminated elements 11 and the magnetic core 2 form a single integrated structure.

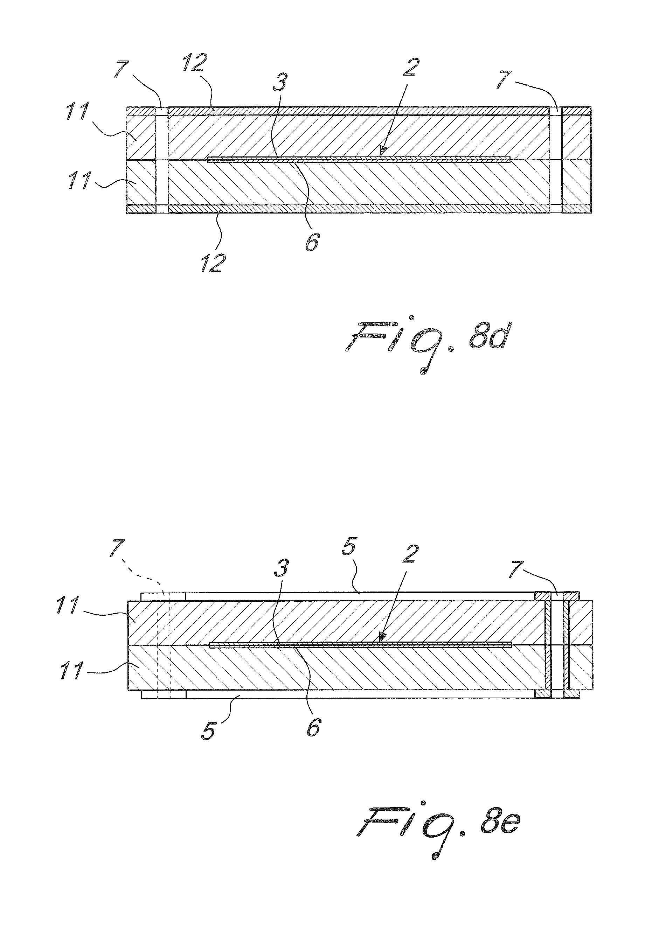

As shown in Figure 8d, in order to obtain an electric interconnection between the two opposite conductive surfaces 12, there are provided through holes 13 at predetermined positions. The perforation may be for example mechanical, laser, or by chemical incision.

The successive matallization of the internal walls of the through holes 13, by means of a process of electrochemical re-covering, allows to provide the conductive holes 7 and the consequent electrical connection between the two conductive surfaces 12, as it is illustrated in Figure 8e.

Finally, the conductive tracks 5 are defined by means of photolithography and successive chemical incision on the conductive surfaces 12.

Alternatively, other techniques conventionally employed in the manufacture of printed circuits may be used, such as selective metallization of the conductive tracks by physical, chemical, or electrochemical deposition, or the direct printing with conductive inks on the external faces 4a.

It is seen in practice how the described invention achieves the proposed aim and objects and in particular the fact is highlighted that the magnetic sensor is reproducible in series, with contained costs and with relatively reduced dimensions, employing opportune combinations of techniques, processes and methodologies generally used in the manufacture of printed circuits.

Moreover, the described method can be completely automized and allows to provide magnetic sensors with neglibible margins of error.

The magnetic sensors produced in this manner, and in particular the provision of the winding with conductive tracks connected by respective conductive holes, guarantee a limited possibility of breakages due, for example, to the interruption of the electric circuit by breakage of the winding.

The invention thus conceived is susceptible to numerous modifications and variations, all of which are within the scope of the appended claims.

Moreover, all of the details may be substituted with other technically equivalent elements.

In practice, the materials employed, as well as the dimensions and contingent shapes, may be any according to requirements without thereby falling outside of the scope of protection of the appended claims.

The disclosures in Italian Patent Application No. M02005A000293 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A magnetic sensor, particularly for measuring the position and movement of an object, comprising at least one winding of electrically conducting material that is arranged around a magnetic core, **characterized in that** said magnetic core comprises at least one layer of magnetic material and is interposed between at least two plates of dielectric material, said plates being provided with respective conductive tracks that are mutually connected to form said at least one winding.

2. The magnetic sensor according to claim 1, **characterized in that** said magnetic core is shaped substantially as a lamina.

3. The magnetic sensor according to one or more of the preceding claims, **characterized in that** said magnetic core comprises at least one support and reinforcement layer for said at least one layer of magnetic material.

4. The magnetic sensor according to one or more of the preceding claims, **characterized in that** said magnetic core comprises a plurality of said layers of magnetic material and a plurality of said support layers mutually alternately overlapping.

5. The magnetic sensor according to one or more of the preceding claims, **characterized in that** said magnetic core is interposed between said two plates and fixed thereto at respective internal faces.

6. The magnetic sensor according to one or more of the preceding claims, **characterized in that** said magnetic core is fixed to said internal faces by gluing.

7. The magnetic sensor according to one or more of the preceding claims, **characterized in that** said conductive tracks are defined on respective external faces of said plates that are opposite to said internal faces and that are mutually connected by conductive through holes.

8. The magnetic sensor according to one or more of the preceding claims, **characterized in that** it comprises a plurality of said conductive tracks that are shaped substantially in linear portions that are mutually spaced and parallel and substantially inclined on said external faces, each of said portions defined on one of said plates being connected by at least one conductive hole to at least one respective portion on the other one of said plates.

9. The magnetic sensor according to one or more of the preceding claims, **characterized in that** said at least one layer is constituted by highly permeable magnetic alloys in the crystalline, nano-crystalline, or amorphous state.

10. The magnetic sensor according to one or more of the preceding claims, **characterized in that** said at least one layer of magnetic material is provided in rigid-type material.

11. The magnetic sensor according to one or more of the preceding claims, **characterized in that** said at least one layer of magnetic material is provided in flexible-type material.

12. The magnetic sensor according to one or more of the preceding claims, **characterized in that** said at least one layer of magnetic material is provided by selective deposition or printing of magnetic materials.

13. The magnetic sensor according to one or more of the preceding claims, **characterized in that** said plates are provided in rigid-type dielectric material.

14. The magnetic sensor according to one or more of the preceding claims, **characterized in that** said plates are provided in flexible-type dielectric material.

15. The magnetic sensor according to one or more of the preceding claims, **characterized in that** said tracks are provided using conductive materials such as copper, aluminium, or silver or in conductive materials such as sheets, pastes, or inks.

16. A method for manufacturing a magnetic sensor, **characterized in that** it comprises the steps of:
- providing a magnetic core;
- interposing said magnetic core between at least two plates of dielectric material;
- forming conductive tracks on respective opposing faces of said at least two plates and connecting said tracks on opposed faces to define at least one electrically conductive winding around said magnetic core.

17. The method according to claim 16, **characterized in that** said step of providing a magnetic core comprises fixing at least one layer of magnetic material to at least one support layer.

18. The method according to claim 17, **characterized in that** said step of fixing comprises overlapping and gluing at least one sheet of soft magnetic alloy to said at least one support layer.

19. The method according to one or more of claims 16-18, **characterized in that** said step of fixing comprises selective depositing or printing of magnetic-type material on said at least one support layer.

20. The method according to one or more of claims 16-19, **characterized in that** said step of providing a magnetic core comprises shaping said layers of magnetic material and of support for defining an open or closed magnetic circuit having at least one branch.

21. The method according to one or more of claims 16-20, **characterized in that** said interposing step comprises gluing said plates to said magnetic core by interposing adhesive layers.

22. The method according to claims 16-21, **characterized in that** said interposing step comprises a cold or hot lamination.

23. The method according to claims 16-22, **characterized in that** said step of forming conductive tracks comprises photolithography and the successive chemical incision on respective conductive surfaces defined on each of said external faces.

24. The method according to one or more of claims 16-23, **characterized in that** said step of forming conductive tracks comprises the selective metalization of said tracks by physical, chemical, or electrochemical deposition on each of said external faces.

25. The method according to claims 16-24, **characterized in that** said step of forming conductive tracks comprises printing on each of said external faces with conductive inks.

26. The method according to claims 16-25, **characterized in that** said step of connecting said conductive tracks on opposed faces comprises providing interconnecting conductive holes between said tracks.

27. The method according to one or more of claims 16-26, **characterized in that** the step of providing said conductive holes comprises perforation of said plates to form through holes and the metalization of said through holes.

28. Use of a magnetic sensor according to claims 1 to 15, for measuring the position and the linear movement of an object.

29. Use of a magnetic sensor according to claims 1 to 15, for measuring the position and the angular movement of an object.

30. Use of a magnetic sensor according to claims 1 to 15, for detecting the proximity of a metallic object.

31. Use of a magnetic sensor according to claims 1 to 15, for measuring the intensity of an external magnetic field.
